# EUROPÄISCHE PATENTSCHRIFT

(11) **EP 2 494 591 B1**
(45) Veröffentlichungstag und Bekanntmachung des Hinweises auf die Patenterteilung: **31.07.2019**
(21) Anmeldenummer: 09765024.6
(22) Anmeldetag: 27.11.2009
(51) Int. Cl.: H01L 21/67, H01L 21/677

(54) **MODUL FÜR MODULAR AUFGEBAUTE REINRAUMANLAGEN**
MODULE FOR MODULARLY CONSTRUCTED CLEAN-ROOM FACILITIES
INSTALLATION DE CONSTRUCTION MODULAIRE POUR SALLE BLANCHE

(30) Priorität: 29.10.2009 DE 102009051173
(43) Veröffentlichungstag der Anmeldung: 05.09.2012
(73) Patentinhaber: ASYS Automatic Systems GmbH & Co. KG, 73614 Schorndorf (DE)
(72) Erfinder: Hügler, Klaus, D-73630 Remshalden (DE)
(74) Vertreter: Müller, Gottfried
(86) Internationale Anmeldenummer: PCT/EP2009/008455
(87) Internationale Veröffentlichungsnummer: WO 2011/050829

(56) Entgegenhaltungen:
- WO-A1-02/36849
- DE-A1- 19 831 032
- JP-A- 7 109 024
- JP-A- 2000 317 867
- US-B1- 6 570 286

## Beschreibung

Die Erfindung betrifft ein Modul für modular aufgebaute Reinraumanlagen gemäß dem Oberbegriff des Anspruches 1.

Modular aufgebaute Reinraumanlagen sind in vielfältigen Ausgestaltungsformen bekannt. Zum Einsatz in solchen Reinraumanlagen kommen auch Module, in denen Arbeitsatmosphären gefordert sind, die im Rein- oder sogar Reinstraumbereich liegen. Solche Module, in denen ein Hochvakuum, und sogar fallweise ein Ultra-Hochvakuum gefordert ist, also Drücke gefordert sind, die bis in den Bereich von 10⁻¹²bar reichen, erfordern in ihrem Aufbau, insbesondere auch hinsichtlich ihrer Antriebsverbindungen in Räume oder Raumabschnitte, die solchen Extrembedingungen unterworfen sind, Ausgestaltungen, die nicht nur nahezu absolut gegen die jeweilige Umgebung abgrenzen, sondern auch unter den jeweiligen Arbeitsbedingungen kaum Partikel freisetzen.

Dies gilt auch für Module, wie sie beispielsweise aus der DE 198 31 032 C2 bekannt sind, die eine Speicher- und eine Handhabungseinheit aufnehmen, die jeweils angetrieben sind und bei denen die Handhabungseinheit als mehrgliedriger Transportarmbeispielsweise in von SCARA-Robotern bekannter Bauweise - ausgebildet ist, was zusätzliche Schwierigkeiten bei der Vermeidung von Verunreinigungen der jeweiligen Arbeitsatmosphäre durch zum Beispiel reibungsbedingt entstehende Partikel bedingt.

Aus der WO 02/36849 A1 ist es bezogen auf Reinraumanlagen mit einem in einem Gehäuseinnenraum angeordneten Handhabungsgerät bekannt, dieses Handhabungsgerät mit arbeitsbedingt gegeneinander beweglichen Armteilen auszubilden, zumindest teilweise zu kapseln und lediglich bezüglich seines Greiferarmes außerhalb dieser Kapselung zu belassen. Die hierfür vorgesehene Kapsel weist in der Bewegungsebene zwischen dem Greiferarm und dem um eine Festachse drehbeweglich abgestützten, motorisch verdrehbaren und zum Greiferarm ebenenparallel beweglichen, einen Tragarm bildenden Antriebsteil eine membranartige Trennwand auf, die bezogen auf die Abstützung des Greiferarmes gegen das Antriebsteil im Wesentlichen lediglich drucksteif kraftübertragend, aber nicht tragend ausgebildet ist. Die Antriebsverbindung zwischen dem Antriebsteil und dem Greiferarm erfolgt über einen zum Antriebsteil als Tragarm drehfest und längs desselben motorisch verstellbar angeordneten Schlepper und einen den Greiferarm tragenden Läufer. Schlepper und Läufer weisen Tragstrukturen auf, die Magnetpaarungen aufnehmen, und sind über diese Magnetpaarungen überbrückend zur Trennwand drehfest und zentrierend gekoppelt sind. Ferner sind die Tragstrukturen mit Stützrollen versehen, die, einander bezogen auf die dazwischenliegende membranartige Trennwand gegenüberliegend, aufeinander abgestützt sind.

Aus der US 6,570,286 B1 ist eine Vorrichtung zur Aufrechterhaltung von Vakuumbedingungen bekannt, bei der eine Sorptionpumpe zur Partikelreduktion in einem evakuierten Raum einer Magnetlagerung verwendet wird.

Der Erfindung liegt die Aufgabe zugrunde, ein Modul für modular aufgebaute Reinraumanlagen in seinem Aufbau dahingehend auszugestalten, dass die Arbeitsatmosphäre, die bis ins Ultra-Hochvakuum reicht, beeinträchtigende Verunreinigungen, wie zum Beispiel Fremdgase, Kohlenwasserstoffe, Partikel, vor allem auch aus Schmierstoffen resultierende Verunreinigungen, zumindest weitgehend vermieden werden.

Hierzu ist der Gehäuseinnenraum eines Moduls in zwei Raumteile unterteilt, deren einer den Greiferarm, und gegebenenfalls eine Speichereinheit aufnimmt und in deren anderem als Kapsel hermetisch getrennt, der Antriebsteil für den Greiferarm untergebracht ist. Die Kapsel weist eine im Übergang zwischen dem Antriebsteil als Tragarm für den Greiferarm und dem Greiferarm liegende, den Innenraum der Kapsel gegen den Gehäuseinnenraum abgrenzende Trennwand auf, über die als Zwischenlage das in der Kapsel liegende Antriebsteil und der außerhalb der Kapsel im Gehäuseinnenraum liegende Greiferarm über Stützrollen aufeinander abgestützt sind. Parallel zu dieser Abstützung, bei der die Trennwand lediglich druckbeaufschlagt zwischen Antriebsteil und Greiferarm liegt, sind das Antriebsteil und der Greiferarm ihrerseits berührungsfrei magnetisch drehgekoppelt. Die Möglichkeit der Verunreinigung des den Greiferarm aufnehmenden Teiles des Gehäuseinnenraumes und des in diesem aufgebauten Reinraumklimas - mit bis in den Bereich des Hochvakuums (10⁻¹²bar) reichenden Drücken - ist dadurch auf Belastungen durch Partikel beschränkt, die sich durch die Lage des Greiferarms im Gehäuseinnenraum und dessen Abstützung zur Trennwand oder an der Trennwand ergeben.

Das Antriebsteil und der Greiferarm sind über eine Drehabstützung verbunden, die einen zum Antriebsteil drehbar angetriebenen Schlepper und einen zum Greiferarm drehfest angeordneten Läufer aufweist und bei der der Schlepper und der Läufer, einander zur Trennwand gegenüberliegend, berührungsfrei über Magnetpaarungen magnetisch drehgekoppelt, und auch magnetisch tragend über die dazwischenliegende Trennwand aufeinander abgestützt sind.

Für die Magnetpaarungen ist eine Ausgestaltung vorgesehen, bei der längs der Verbindung zwischen zueinander beabstandeten Rollenabstützungen sowohl "zentrierende" Magnetpaarungen mit mit ihren Gegenpolen einander gegenüberliegenden Magneten wie auch tragende, "abstützende" Magnetpaarungen vorgesehen sind, deren Magneten mit ihren Gleichpolen einander zugewandt sind. Es lässt sich so eine Entlastung der Rollenabstützungen erreichen, und gleichzeitig, da der Rollwiderstand der Rollenabstützungen verringert wird, eine Lösung erreichen, die eine besonders genaue Bewegungskopplung von Läufer und Schlepper ermöglicht. Zudem werden die Rollen entlastet, so dass sich auch in den Berührungsflächen zwischen Rollen und Trennwand ein verringerter Abrieb und eine weitere Verringerung der ohnehin sehr geringen Partikelbelastung ergibt, insbesondere beispielsweise auch durch die Verwendung keramischer Rollen.

Die über die Magnetpaarungen erreichbare Bewegungskoordination von Schlepper und Läufer, also die zentrierende Ausrichtung derselben gegeneinander, lässt sich durch entsprechende Anordnung der Rollenabstützungen und Zusammenfassung in Stürzrollengruppen in vorteilhafter Weise beeinflussen, die jeweils durch zur Trennwand gegenüberliegende Stützrollen gebildet sind. Eine Stützrollengruppe umfasst mehrere Stützrollen, von denen, bezogen auf drei Stützrollen, zwei auf einer Seite der Trennwand liegende auf gleichem Umkreis oder Radius zur Drehachse der Drehabstützung zueinander derart beabstandet angeordnet sind, dass eine Dritte gegenüberliegende und auf einem abweichenden Umkreis oder Radius angeordnete, insbesondere auf einem kleineren Radius angeordnete zu diesen, bezogen auf die Umkreise, eine etwa angrenzende Lage einnimmt. Bezogen auf eine Stützrollenabstützung mit drei Stützrollen liegen die Stützrollen mit ihren Mittelpunkten somit etwa in Überdeckung zu den Eckpunkten eines Stützdreiecks. Eine entsprechende Ausgestaltung mit einer größeren Anzahl von Stützrollen liegt im Rahmen der Erfindung.

Bezogen auf die etwas versetzt gegenüberliegende Lage der Stützrollen ist die Trennwand nicht nur druck- sondern auch kraftbeaufschlagt und es bilden sich um die Stützrollen jeweils flach eingewölbte, muldenförmige Vertiefungen, die aufgrund der Lage der Stützrollen zueinander eine wechselseitige Ausrichtung des Läufers auf eine zum Schlepper konzentrische Lage zur Folge haben und die somit stabilisierend wirken.

Die Reibung der über die jeweilige Tragstruktur gegen die Trennwand mit einem Stützsegment als Kuppe leicht überstehenden Stützrollen zur Trennwand kann eine gewisse Partikelbildung nach sich ziehen, auch wenn die Stützrollen in der jeweiligen Tragstruktur besonders reibungsarm abgestützt und weitgehend gekapselt, insbesondere auch schmierstofffrei, angeordnet sind. Um solche Partikel nahe dem Entstehungsort abzufangen, erweist es sich als zweckmäßig, dass zur Sorption umschließend zu der oder den am Läufer vorgesehenen Stützrollen benachbart zur Trennwand am Läufer eine bevorzugt unter Hochspannung stehende Partikelfangschleife vorgesehen wird.

Eine berührungsfrei drehmomentenübertragende Gestaltung der Antriebsverbindung zur insbesondere als Speicherkarussell ausgebildeten Speichereinheit ist über eine magnetisch arbeitende, insbesondere drehfest übertragende und bevorzugt selbstzentrierende Kupplung gestaltet und mittels zentrisch zur Drehachse liegender und mit ihren Gegenpolen einander gegenüberliegender Magneten realisiert, die zu einem Ringspalt umgrenzend vorgesehen sind, der von der Napfwand eines napfförmigen Gehäuseteiles durchsetzt ist, so dass der von der Kupplung durchsetzte Bereich zwischen motorseitigem Antrieb und vom Modulgehäuse umschlossenen und der Gehäuseinnenraum geschlossen ist. In das napfförmige Gehäuseteil greift das bevorzugt ebenfalls napfförmig gestaltete, mit dem Antriebsmotor verbundene Antriebsteil der Kupplung ein, und umfangsseitig ist das napfförmige Gehäuseteil von dem bevorzugt ebenfalls napfförmigen Abtriebsteil der Kupplung umschlossen, das im Bereich seiner Napfwand zum Gehäuse radial gelagert ist. Die radiale Abstützung erfolgt gegen einen Ringbund des Gehäuses, der sich überlappend zur Napfwand des napfförmigen Abtriebteiles der Kupplung erstreckt, so dass das den Ringspalt durchsetzende napfförmige Gehäuseteil und das mit seinem Ringbund die Lager für das Abtriebsteil der Kupplung abstützende Gehäuseteil jeweils als napfförmige Gehäuseteile gestaltet sein können, deren Böden einander gegenüberliegen.

Der die Lagerung in der Abstützung zwischen abtriebsseitigem Kupplungsteil und dieses aufnehmendem ebenfalls napfförmigen Gehäuseteil liegende Ringraum ist somit gegen die Antriebsseite hermetisch abgeschlossen und kann über eine berührungsfrei arbeitende Dichtung zwischen dem napfförmigen abtriebsseitigen Kupplungsteil gegen den Gehäuseinnenraum abgesperrt werden.

Bevorzugt ist der die Lager aufnehmende Ringraum an eine insbesondere durch eine Absaugpumpe gebildete Absaugeinrichtung angeschlossen, so dass auch in diesem Ringraum ein Unterdruck herrscht.

Aufgrund des Druckgefälles zwischen die Lagerung aufnehmendem Ringraum und Gehäuseinnenraum trotz der vorgesehenen Abdichtung etwa über die Abdichtung übertretende Verunreinigungen, sei es in Gasform oder als Partikel, werden in einer Partikelfalle abgefangen, die dadurch gebildet ist, dass in axialer Überdeckung zum gehäuseseitigen, die Lager abstützenden Ringbund unterhalb derselben gegen den Gehäuseinnenraum zu am Abtriebsteil der Kupplung ein Ringkanal vorgesehen ist, der als sorbierende Partikelfalle und insbesondere eine Sorptionspumpe dient. Diese ist bevorzugt als Getterpumpe ausgebildet und weist eine Titandrahtschleife auf, die, zum Beispiel über keramische Scheiben isolierend abgestützt, unter Hochspannung steht, so dass sich eine Sublimation etwa in den Ringraum übergetretener Partikel ergibt.

Trotz der hohen Anforderungen, die dadurch bedingt sind, dass der vom Modulgehäuse umschlossene Innenraum Arbeits- und/oder Speichereinheiten aufnehmen können soll, die als Arbeitsatmosphäre eine Evakuierung bis hin zum Ultra-Hochvakuum teilweise verlangen, ist mit der vorgeschilderten Ausgestaltung einer das Modulgehäuse durchsetzenden Antriebsverbindung eine Ausgestaltung geschaffen, die auch konstruktiv gut zu beherrschen ist und für Montage und Wartung gute Voraussetzungen bietet.

Insbesondere in Verbindung mit Modulen für Reinraumanlagen, in deren Gehäuseinnenraum unterhalb der Antriebsverbindung eine Speicher- und/oder Arbeitseinheit, insbesondere ein Speicherkarussell und unterhalb desselben ein Handhabungsgerät, etwa in Form eines SCARA-Roboters, angeordnet sind, kommt der vorgeschildeten Ausgestaltung der Antriebsverbindung, über die das Speicherkarussell getragen und angetrieben ist, besondere Bedeutung zu, da etwaige, über die Kupplungsverbindung freigesetzte Partikel auf die im Speicherkarussell abgelegten und/oder über das Handhabungsgerät transportierten Substrate "herabregnen", womit für die Substrate in Anbetracht der geforderten extremen Reinheitsbedingungen irreparable Schäden verbunden sein können. Gerade deshalb ist die Ausrüstung derartiger Module in vorstehender Weise zweckdienlich.

Mit den vorgeschilderten Maßnahmen kann einzeln, insbesondere aber auch in der Kombination, die Partikelkonzentration im zu schaffenden oder aufrechtzuerhaltenden Vakuum, bis hin zum Ultra-Hochvakuum, so weit abgesenkt werden, dass für den Arbeitsbetrieb auch sehr extreme Reinheitsanforderungen gewährleistet werden können und somit die Qualität des Arbeitsergebnisses auf ein Verunreinigungen vermeidendes Niveau angehoben werden kann. Weitere Einzelheiten und Merkmale der Erfindung ergeben sich aus den Ansprüchen, der Beschreibung und den Zeichnungen. Es zeigen:
- Fig. 1: einen Schnitt durch ein Modul für modular aufgebaute Reinraumanlagen, das ein einen Gehäuseinnenraum umschließendes Gehäuse aufweist und im Gehäuseinnenraum ein Speicherkarussell und darunter liegend ein Handhabungsgerät aufnimmt,
- Fig. 2: eine der Fig. 1 entsprechende Darstellung, in der auf die Darstellung des Gehäuses des Modules verzichtet ist,
- Fig. 3: in einem Ausschnitt eine vergrößerte Teildarstellung der Antriebsverbindung zum Speicherkarussell,
- Fig. 4: eine Teildarstellung zu Fig. 2, in der der Greiferarm des Handhabungsgerätes in seiner Überdeckungslage zu der im Gehäuseinnenraum liegenden Kapsel gezeigt ist, die einen Teil des Handhabungsgerätes aufnimmt und atmosphärisch gegen den Gehäuseinnenraum abgrenzt, wobei die Kapsel oberseitig eine membranartige Trennwand aufweist, über der sich der Greiferarm des Handhabungsgerätes erstreckt,
- Fig. 5: eine der Fig. 4 entsprechende Darstellung mit dem in der Kapsel liegenden Teil des als SCARA-Roboter ausgebildeten Handhabungsteiles bei von der Kapsel entfernter Trennwand, wobei analaog zu Fig. 4 die in der Verbindung zwischen dem Greiferarm und dem mehrgliedrigen Tragarm liegende Tragabstützung mit ihrem dem Tragarm zugeordneten Teil veranschaulicht ist,
- Fig. 6: eine Ausschnittsvergrößerung, in der von der Tragabstützung die einander zur Tragwand gegenüberliegenden Tragstrukturen mit den zugeordneten Magnetpaarungen und Rollenabstützungen dargestellt sind, sowie
- Fig. 7: in einer Draufsicht auf den Greiferarm, die seitens des Greiferarmes in der Abstützung zur Trennwand vorgesehene Tragabstützung.

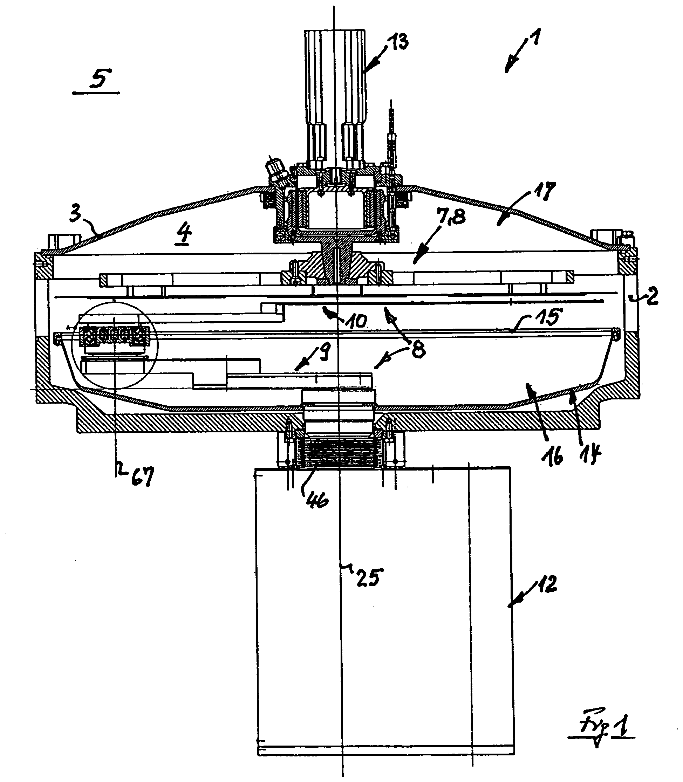

Ein insbesondere in modular aufgebauten Reinraumanlagen einzusetzendes Modul 1 zeigt Fig. 1. Dieses Modul kann kommunizierend mit weiteren, nicht dargestellten Modulen der Reinraumanlage, zu denen auch Ein- und Ausgabestationen gehören, über zumindest eine Übergabeöffnung 2 in nicht dargestellter Weise in Verbindungstehen. Gezeigt sind in der Darstellung gemäß Fig. 1 zwei im Gehäuse 3 des Modul 1 vorgesehene Übergabeöffnungen. Über das Gehäuse 3 ist der Gehäuseinnenraum 4 gegen die Umgebung 5 zum Modul 1 abgegrenzt, in der herkömmliche oder auch in Aufstellräumen für Reinraumanlagen herrschende Sonderbedingungen gegeben sein können.

Das dargestellte Modul nimmt in seinem Gehäuseinnenraum 4 eine als Zwischenspeicher dienende und als Speicherkarussell 6 ausgestaltete Speichereinheit 7 auf, sowie auch ein Handhabungsgerät 8, das im Ausführungsbeispiel nach Art von SCARA-Robotern ausgebildet dargestellt ist und das ein Antriebsteil 9 und einen Greiferarm 10 aufweist. Entsprechende andere Handhabungsgeräte können in Einsatz kommen. Das Antriebsteil 9 und der Greiferarm 10 sind über eine Drehabstützung 11 verbunden, die nachstehend näher erläutert wird. Weiter ist das Antriebsteil 9 drehbar und in Richtung seiner Drehachse hubverstellbar mit einer Antriebseinheit 12 verbunden, die außerhalb des Gehäuses 3 liegt, und zwar bezogen auf das Gehäuse 3 gegenüberliegend zu einer Antriebseinheit 13 für das Speicherkarussell 6.

Das zum Gehäuse 3 drehbar und hubverstellbar angeordnete Antriebsteil 9 liegt innerhalb einer schalenförmigen Kapsel 14, die das Antriebsteil 9 aufnimmt und bei zum Gehäuse 3 drehfester Anordnung mit dem Antriebsteil 9 hubverstellbar ist. Die Kapsel 14 weist als im Übergang zwischen dem Antriebsteil 9 und dem Greiferarm 10 liegende Abdeckung eine membranartige Trennwand 15 auf.

Durch die Kapsel 14 mit ihrer Trennwand 15 ist innerhalb des Gehäuseinnenraumes 4 ein Raumteil 16 abgegrenzt, so dass sich bezogen auf den Gehäuseinnenraum 4 zwei gegeneinander abgegrenzte Raumteile 16 und 17 ergeben, in deren einem, nämlich demRaumteil 16 das Antriebsteil 9 des Handhabungsgerätes 8 liegt und in deren anderem Raumteil 17 das Speicherkarussell 6 und der Greiferarm 10 liegen. Diese Trennung ermöglicht es, in den Raumteilen 16 und 17 voneinander unabhängige atmosphärische Bedingungen zu schaffen und im Hinblick auf den Einsatz des Modules 1 in Reinraumanlagen im Raumteil 17 Arbeitsatmosphären bis hin zum Ultra-Hochvakuum, das heißt bis hin zu etwa 10⁻¹²bar zu realisieren, da sich bei einer derartigen Aufteilung in die Raumteile 16 und 17 hinsichtlich der Verunreinigung solcher Atmosphären das besonders kritische Antriebsteil 9 des Handhabungsgerätes, in entsprechender Weise aber auch andere Teile vom Raumteil 17 separieren und im Raumteil 16 unterbringen lässt. Für dieses Raumteil 16 liegen hinsichtlich der geforderten Unterdruckatmosphäre geringere Anforderungen vor, die bei der über die Trennwand 15 realisierten atmosphärischen Trennung zwischen den Raumteilen 16 und 17 insbesondere durch Festigkeitsüberlegungen bestimmt sind, wenn man die Trennwand als membranartige Trennwand 15 möglichst dünnwandig ausgespannt zum schalenförmigen Unterteil der Kapsel 14 als dessen Abdeckung realisieren will und deshalb große Druckdifferenzen vermeiden muss.

Im Hinblick auf möglichst geringe Hubwege des Greiferarms 10, und damit auch der Kapsel 14 beim Beschicken und Umsetzen von über dem Greiferarm 10 auf Speicherplätzen 18 des Speicherkarussells 6 abzulegenden oder aus diesen Speicherplätzen 18 herauszunehmenden flächigen Substraten sowie einen kollisionsfreien Zugriff auf diese Speicherplätze 18 ist der Greiferarm 10 ausgehend von seinem freien Greiferende gegen die Drehabstützung 11 in seinem längsmittleren Bereich gestuft nach unten abgesetzt, wie über die Stufe 19 angedeutet.

Eine solche an sich bekannte Ausgestaltung des Greiferarms 10 und dessen Zusammenwirken mit dem Speicherkarussell 6 ist ebenso wie die Ausgestaltung des Speicherkarussells 6 im Detail insbesondere aus der DE 198 31 032 C2 bekannt, auf die diesbezüglich verwiesen wird.

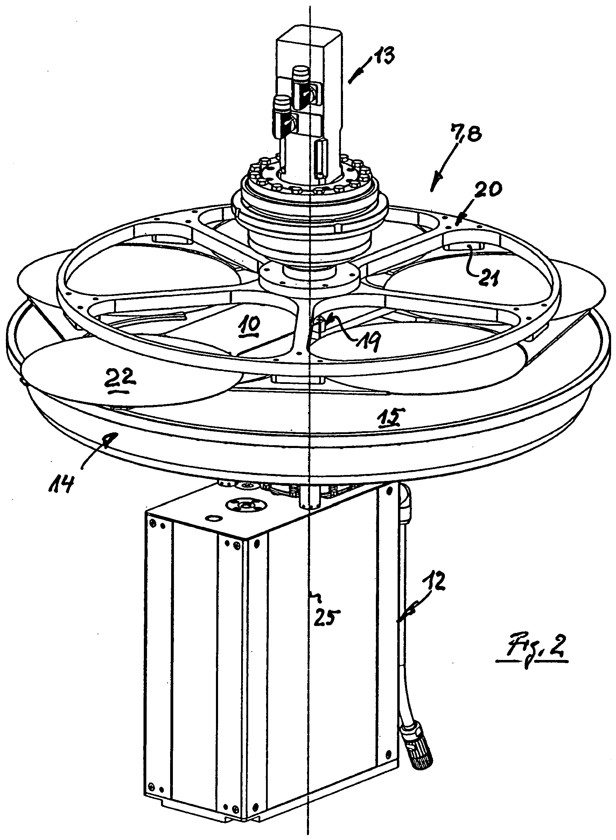

Ersichtlich ist die anhand der Fig. 1 geschilderte Konstruktion des Moduls 1 insbesondere auch aus der perspektivischen Darstellung gemäß Fig. 2, in der das Modul 1 skelettiert ohne das Gehäuse 3 dargestellt ist, und zwar mit dem radförmigen Karussellträger 20 des Speicherkarussells 6 und den unterhalb desselben nahe dessen Umfang vorgesehenen Auflagesegmenten 21 für die scheibenförmigen Substrate 22, welche über den Greiferarm 10 zur Entnahme abgehoben und bei etwa zentraler Lage zum Karussellträger 20 in eine Übergabeebene abgesenkt oder aber über die in Fig. 1 dargestellten Übergabeöffnungen 2 auf ein anderes Modul der Reinraumanlage weitergegeben werden. In entsprechender Weise erfolgt auch die Zuführung von Substraten auf das Modul 1.

Entsprechend der Aufnahme der Antriebseinheit 12 des Handhabungsgerätes 8 in der Kapsel 14 und der geschlossenen Darstellung der Kapsel 14 in Fig. 2 ist vom Handhabungsgerät 8 nur der Greiferarm 10 mit einem von diesem in der dargestellten Arbeitssituation getragenen Substrat 22 in seiner durch die Stufe 19 abgesetzten Ausgestaltung ersichtlich, durch die ein kollisionsfreies Verfahren des Greiferarms 10 nach Abheben eines jeweiligen Substrates 22 aus den jeweiligen Auflagesegmenten 21 und ein Verfahren des jeweils abgehobenen Substrates 22 bis in den zentralen Bereich des Karussellträgers 20 möglich, in dem das jeweils herauszunehmende, und entsprechend auch ein jeweils auf dem Karussellträger 20 abzulegende Substrat 22 überschneidungsfrei zu den sonstigen, vom Karussellträger 20 getragenen Substraten 22 in Hubrichtung verlagert werden kann.

Bei der Umsetzung der Substrate 22 mittels des Handhabungsgerätes 8 durchlaufen die Substrate 22 somit jeweils den zentralen Mittenbereich des Moduls 1, in dem sich die gehäuseseitige Lagerung 23 für das Speicherkarussell 6 im Übergang zur Antriebseinheit 13 befindet. Dort anfallende und eventuell auf den Gehäuseinnenraum 4, in dem eine Rein- oder Reinstraumatmosphäre mit bis zu 10⁻¹²bar herrschen kann, übertretende Verunreinigungen, insbesondere Partikel gefährden somit bezogen auf die Substrate 22 das Arbeitsergebnis insbesondere in deren Durchlaufweg durch den zentralen Mittenbereich. Im Hinblick darauf ist die über die Lagerung 23 abgestützte Antriebsverbindung 24 berührungsfrei drehmomentenübertragend ausgebildet, so dass die Antriebsverbindung 24 keinen abzudichtenden Übergang zwischen der Umgebung 5 und dem Gehäuseinnenraum 4 bedingt.

Erreicht wird dies durch die Ausgestaltung der Antriebsverbindung 24 als magnetische, selbstzentrierend drehfeste Kupplung mit zentrisch zur gemeinsamen Drehachse 25 liegenden Magneten 26, 27, die mit ihren Gegenpolen einander gegenüberliegend einen Ringspalt 28 umgrenzen, der von der Napfwand 29 eines napfförmigen Gehäuseteiles 30 durchsetzt ist. Dieses napfförmige Gehäuseteil 30 ist gegen die Antriebseinheit 13 offenen Napf gestaltet, der den antriebsseitigen Teil 31 der Kupplung aufnimmt. Der abtriebsseitige Teil 32 der Kupplung ist als gegen die Antriebsseite offener, den napfförmigen Gehäuseteil 30 übergreifender, offener Napf ausgebildet, dessen Napfwand als Ringwand 72 radial innen die Magnete 27 trägt und radial außen über die Lagerung 23 mit den Radiallagern 33 gegen einen Ringbund 37 des Gehäuses 3 abgestützt ist.

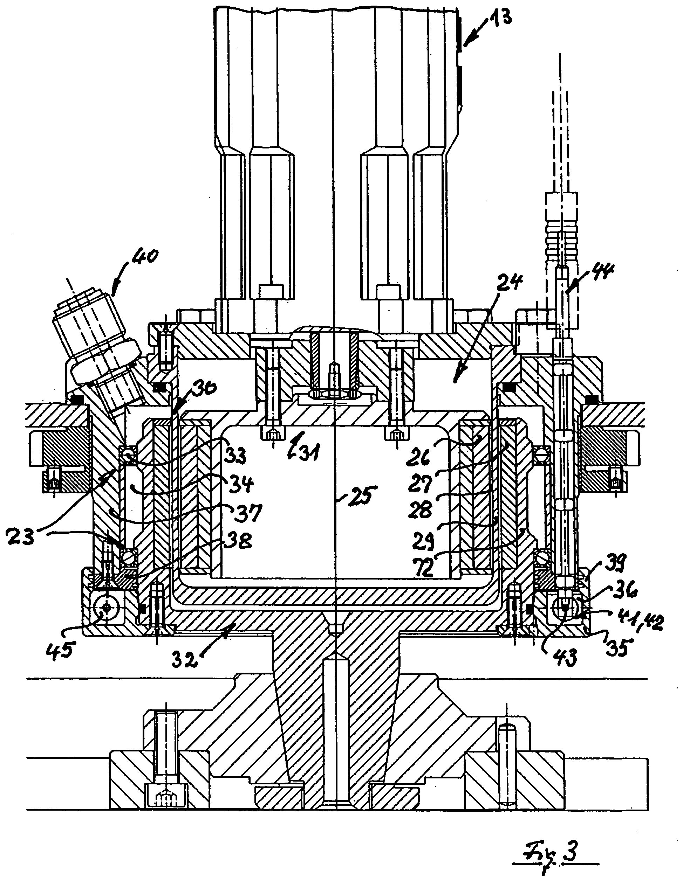

Die Lagerung 32 liegt somit in einem gehäuseseitig umgrenzenden und gegen den Gehäuseinnenraum 4 offenen Ringraum 34, in den das abtriebsseitige, als Napf ausgestaltete Kupplungsteil 32 mit seiner Ringwand 72 eingreift und der, wie Fig. 3 zeigt, über einen am abtriebsseitigen Teil 32 der Kupplung radial angesetzten Ringkörper 35 gegen den Gehäuseraum 4 dichtend abgegrenzt ist.

Hierzu ist der Ringkörper 35 mit einem Ringraum 36 versehen, und im Übergang vom Ringkörper 35 zum die Lagerung 23 aufnehmenden Ringraum 34 liegt ein zum Ringbund 37 lagefest angesetzter Sperrring 38, der den Ringraum 36 gegen den die Lagerung 23 aufnehmenden Ringraum 34 und gegen den Gehäuseinnenraum 4 atmosphärisch abgrenzt. Der Sperrring 38 weist hierzu in seiner der Napfwand des abströmseitigen Kupplungsteiles 32 zugewandten Ringfläche ein Dichtungslabyrinth auf, und ein weiteres Dichtungslabyrinth auf seiner außenseitigen Umfangsfläche, die von einem radial außen am Ringkörper 35 vorgesehenen und axial überstehenden Ringabsatz 39 des Ringkörpers 35 übergriffen ist.

An den die Lagerung 23 aufnehmenden Ringraum 34 ist, wie angedeutet, eine Absaugvorrichtung 40 angeschlossen, so dass über die Lagerung 22 oder in sonstiger Weise im Ringraum 34 anfallende Partikel im Wesentlichen bereits über die Absaugvorrichtung 40 entfernt werden. Verbleibende Verunreinigungen, insbesondere Partikel könnten aufgrund des gegebenen Druckgefälles zum Gehäuseinnenraum über die Spaltabdichtung zwischen dem Sperrring 38 und der Napfwand des abtriebsseitigen Kupplungsteiles 32 auf den Ringraum 36 übertreten und von dort über die Dichtgrenze zwischen dem Sperrring 38 und dem übergreifenden Ringabschnitt 39 des Ringkörpers 35 in den Gehäuseinnenraum 4 gelangen.

Um zu verhindern, dass über diesen Weg Partikel in den Gehäuseinnenraum 4 gelangen, ist erfindungsgemäß im Ringraum 36 durch die Anordnung einer Sorptionspumpe 41 eine Partikelfalle 42 geschaffen. Die als Getterpumpe ausgebildete Sorptionspumpe 41 ist in ihrer Funktion bekannt und dargestellt in einem schematisierten Grundaufbau mit im Ringraum 36 liegendem Drahtring 43, zum Beispiel einem Titanring, der über eine den Sperrring 38 und den Ringbund 37 durchsetzende Leitungsverbindung mit einer Spannungsquelle verbunden ist und der, beispielsweise über Keramikscheiben 45 isolierend zum Ringkörper 35 abgestützt ist.

Die so geschaffene Verbindung zwischen der Antriebseinheit 13 und dem abtriebsseitigen Kupplungsteil 32 mit tragender Abstützung des Speicherkarussells 6 gegen das Gehäuse 3 stellt eine hermetische Abdichtung zwischen der Umgebung 5 und dem Gehäuseinnenraum 4 sicher und gewährleistet auch, dass nahezu keine die Rein- oder Reinstraumatmosphäre des Gehäuseinnenraumes 4 ergebende Verunreinigungen, insbesondere auf den Substraten ablagernde Partikel, freigesetzt werden.

In Verbindung mit der Anordnung des Antriebsteiles 9 des Handhabungsgerätes 8 in der zum Gehäuse 3 drehfesten und bevorzugt mit der Antriebseinheit 12 hubverstellbaren Kapsel 14 bei bevorzugt über eine Balgverbindung 46 gegen die Umgebung 5 abgegrenzten Übergang zwischen der Antriebseinheit 12 und dem Gehäuse 3 ist die Durchführung der Antriebsverbindung von der Antriebseinheit 12 zum in der Kapsel 14 liegenden Antriebsteil 9 des Handhabungsgerätes 8 ohne Gefahr für die Verunreinigung des Gehäuseinnenraums 4, insbesondere mit Partikeln, einfach zu beherrschen. Somit liegt lediglich die Antriebsverbindung zwischen dem Antriebsteil 9 und dem Greiferarm 10 über die Drehabstützung 11 teilweise im Rein- oder Reinstraumbereich, wobei aufgrund der berührungsfrei magnetischen Bewegungskopplung in der erfindungsgemäßen Ausgestaltung auch insoweit Verunreinigungen des Rein- oder Reinstraumbereiches weitgehend vermieden werden können.

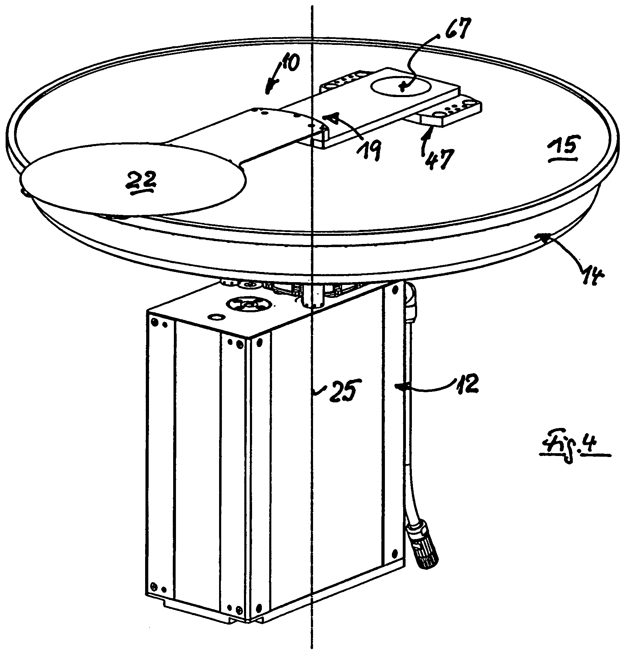

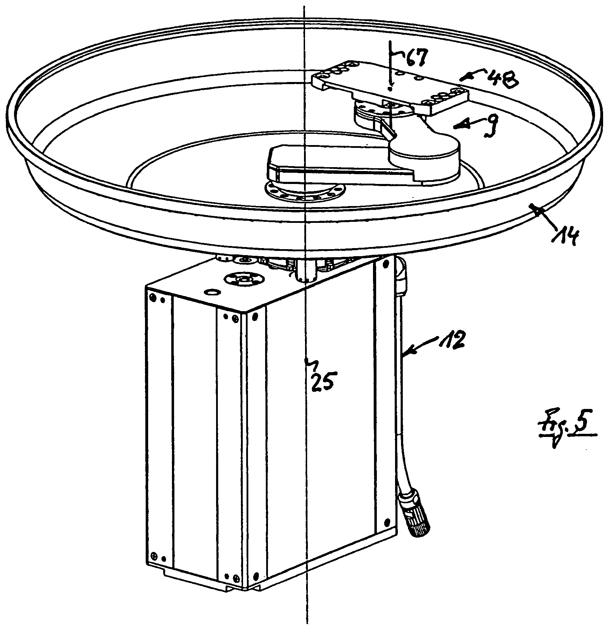

Die Fig. 4 und 5 zeigen die Ausgestaltung der Drehabstützung 11 in Fig. 4 bezüglich deren dem Greiferarm 10 zugehörigen Teiles, der als zum Greiferarm 10 drehfester Läufer 47 ausgestaltet ist und an der Trennwand 15 anliegt. In der Darstellung gemäß Fig. 5, die die Kapsel 14 ohne die Trennwand 14 zeigt, ist der dem als Gelenkarm ausgestalteten Antriebsteil 9 zugehörige Teil der Drehabstützung 11 gezeigt, der als Schlepper 48 von unten gegen die Trennwand 15 anliegt, wie dies aus Fig. 1 ersichtlich ist. Der Schlepper 48 ist zum Armteil 49 drehverstellbar angetrieben abgestützt.

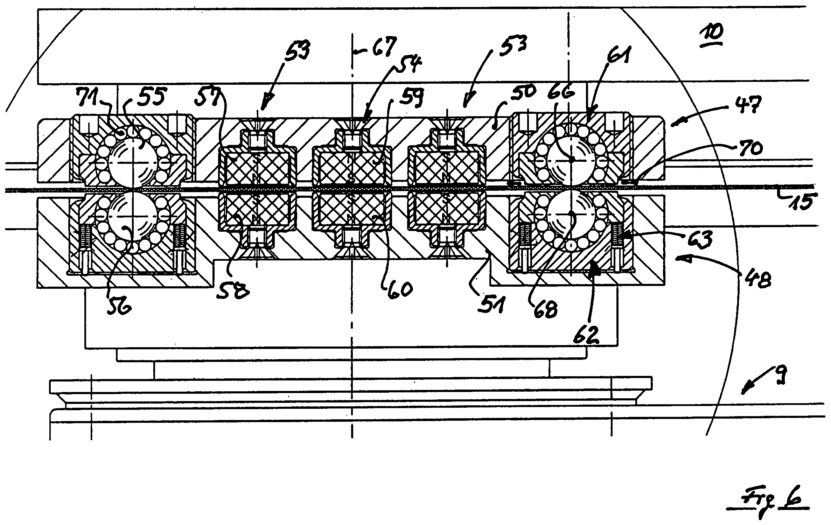

Sowohl der Läufer 47 als auch der Schlepper 48 weisen jeweils eine zur Ebene der Trennwand 15 sich parallel erstreckende Tragstruktur 50 bzw. 51 auf, und in diesen Tragstrukturen 50, 51 sind Rollenabstützungen 52 sowie Magnetpaarungen 53, 54 angeordnet. Die Rollenabstützungen 52 sind, wie in Fig. 6 prinzipiell dargestellt, durch einander zur Trennwand 15 gegenüberliegende und in den Tragstrukturen 50 bzw. 51 gehaltene, drehbar gelagerte Stützrollen 55 bzw. 56 gebildet. Von den Magnetpaarungen sind die Magnetpaarungen 53 als zentrierende Magnetpaarungen durch mit ihren Gegenpolen einander gegenüberliegende Magneten 57, 58 gebildet.

Gezeigt sind in Fig. 6 als im Bereich zwischen zwei Rollenabstützungen 52 liegende Magnetpaarungen sowohl Magnetpaarungen 53 mit mit ihren Gegenpolen einander gegenüberliegenden Magneten 57, 58 als auch Magnetpaarungen 54, die als abstützende Magnetpaarungen durch mit ihren Gleichpolen einander gegenüberliegende Magneten 59, 60 gebildet sind. Die Magnetpaarungen 53, 54 sind insbesondere mit Permanentmagneten aufgebaut und hinsichtlich der jeweils ausgeübten, zentrierend anziehenden Kräfte der Magnetpaarungen 53 und der abstoßenden Kräfte der Magnetpaarungen 54 so aufeinander abgestimmt, dass sich eine Bewegungskopplung zwischen Läufer 47 und Schlepper 48 bei möglichst geringen, über die Rollenabstützungen 52 abzufangenden Stütz- und Tragkräften ergibt.

Die Ausgestaltung der Rollenabstützungen 52 bezüglich der Lagerungen der in diesen aufgenommenen Rollen 55 bzw. 56 ist prinzipiell gleich und es ist jede der Rollen 55, 56 außerhalb ihres der Trennwand 15 zugewandten und auf der Trennwand 15 aufliegenden Segmentes in einem Rollenkäfig 61 bzw. 62 mit die Stützrollen 55 bzw. 56 zum Käfig 61, 62 abstützenden Lagerrollen aufgenommen. Der jeweilige Rollenkäfig 61, 62 ist bezüglich seines die Lagerrollen 71 aufnehmenden Kugelringraumes benachbart zur Trennwand 15 durch ein Einsatzteil zum jeweiligen Rollenkäfig 61 bzw. 62 nahezu spaltfrei bis auf die Durchlassöffnung für das zur Trennwand 15 tragende Segment der jeweiligen Rolle 55, 56 geschlossen.

Aus Fig. 6 ist des Weiteren ersichtlich, dass die dem Schlepper 48 zugeordneten und untergreifend zur Trennwand 15 liegenden Stützrollen 56 über ihre jeweiligen Rollenkäfige 62 federnd zur Tragstruktur 51 abgestützt gegen die Trennwand 15 angelegt sind, so dass bei der angestrebten zur Trennwand 15 ebenenparallel beweglichen Verfahrbarkeit von Läufer 47 und Schlepper 48 die wechselseitige Abstützung auch bei etwa auftretenden Verformungen der Trennwand 15 aufrechterhalten bleibt, bei entsprechender Begrenzung der Stützkraft. Die federnden Abstützungen sind bei 63 symbolisch angedeutet, und zwar im Übergang zwischen dem jeweiligen Rollenkäfig 62 und der zugehörigen Tragstruktur 51.

Fig. 6 lässt auch erkennen, dass die Magneten 57, 58 bzw. 59, 60 der Magnetpaarungen 53, 54 zur Tragstruktur 50 bzw. 51 bevorzugt jeweils in ihrer axialen Lage zur durch die Trennwand 15 bestimmten Ebene beispielsweise über Schraubverbindungen einstellbar sind. Eine entsprechende Einstellbarkeit kann insbesondere auch für die fest mit ihrer Tragstruktur 50 verbundenen Rollenkäfige 61 dadurch erreicht werden, dass diese über eine Gewindeverbindung zur Tragstruktur 50 festgelegt werden.

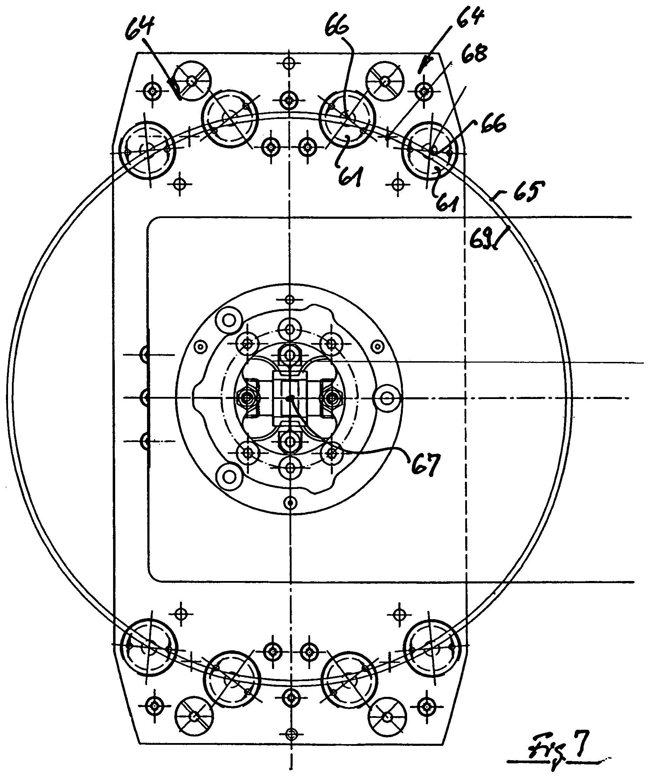

Fig. 7 verdeutlicht analog zu den Fig. 4 und 5, dass die verkoppelnde Abstützung zwischen Läufer 47 und Schlepper 48 bevorzugt dadurch erfolgt, dass die einander entsprechenden Tragstrukturen 50, 51 eine größere Anzahl von Rollenabstützungen 52 aufweisen, die zueinander versetzt bevorzugt in den Eckpunkten eines Mehrecks, so insbesondere eines Dreiecks oder Vierecks, angeordnet sind, wobei die Darstellungen von einer Anordnung der Rollenabstützungen 52 in den Eckpunkten eines Vierecks ausgehen, und zwar über jeweils eine Stützrollengruppe 64 in jedem der Eckpunkte.

Fig. 7 veranschaulicht, entsprechend Fig. 4, eine Draufsicht auf den Greiferarm 10 bei unterhalb des Greiferarms 10 liegendem und mit diesem drehfest verbundenen, in der Draufsicht viereckigem Läufer 47 sowie in den Eckpunkten dieses Läufers 47 angeordneten Stützrollengruppen 64. Jede dieser Stützrollengruppen 64 umfasst mehrere, im Ausführungsbeispiel zwei läuferseitige Stützrollen 55 mit den diese aufnehmenden Rollenkäfigen 61, wobei die Stützrollen 55 mit ihren Mittelpunkten 66 auf einem gemeinsamen Umkreis 65 um die Drehachse 67 der durch den Läufer 47 und den Schlepper 48 realisierten Drehabstützung zwischen Antriebsteil 9 und Greiferarm 10 liegen. Die Stützrollen 55 der jeweiligen Stützrollengruppe 64 sind in Umfangsrichtung des Umkreises 65 gegeneinander versetzt und im Übergangsbereich zwischen den Mittelpunkten 66 der einer Stützrollengruppe 64 zugeordneten Stützrollen 55 liegt gleich beabstandet zu deren Mittelpunkten 66 der Mittelpunkt 68 der schlepperseitigen Stützrolle 56 der Stützrollengruppe 64.

Der Mittelpunkt 68 der schlepperseitigen Stützrollengruppe 64 liegt dabei auf einem im Radius zum Umkreis 65 abweichenden Umkreis 69, wobei der Radius des Umkreises 69 bezogen auf das Ausführungsbeispiel kleiner als der Radius des Umkreises 65 ist, so dass die Mittelpunkte 66 der läuferseitigen Stützrollen 65 und der Mittelpunkt 68 der schlepperseitigen Stützrolle 56 einer Stützrollengruppe 64 jeweils auf den Eckpunkten eines gleichseitigen stumpfwinkligen Dreiecks liegen, mit dessen Scheitel der Mittelpunkt der schlepperseitigen Stützrolle 56 zusammenfällt. Der stumpfe Scheitelwinkel ist, wie das Ausführungsbeispiel veranschaulicht, nur wenig kleiner als 180°.

Eine solche Anordnung der Stützrollen 55, 56 einer Stützrollengruppe 64 kann in Verbindung mit der membranartigen Ausgestaltung der Trennwand 15 aufgrund der von den Stützrollen 55, 56 auf die Trennwand 15 ausgeübten Kräfte zu muldenartigen Einformungen führen, die aufgrund der in Draufsicht angrenzenden Lage der Stützrollen 55, 56 zueinander zu einer wechselseitigen Ausrichtung von Läufer 47 und Schlepper 48 auf ihre zentrale Überdeckungslage führen.

Infolge der durch die in den Rollenkäfigen 61, 62 weitgehend gekapselten Anordnung der Stützrollen 55, 56 und ihrer Lagerungen sowie auch aufgrund dessen, dass über die Stützrollen 55, 56 keine Antriebskräfte zu übertragen sind und die erfindungsgemäße Ausbildung der Magnetpaarungen 53, 54 auch ermöglicht, die übertragenden Stützkräfte verhältnismäßig klein zu halten, ergibt sich bei entsprechender Wahl der Werkstoffe für die membranartige Trennwand 15 und die Stützrollen 55, 56 nur ein minimaler Abrieb. Dieser Abrieb kann erfindungsgemäß zudem dadurch läuferseitig im Wesentlichen eingefangen werden, dass umschließend zum der Trennwand 15 zugewandten, vom Rollenkäfig 61 nicht abgedeckten Stützsegment einer jeweiligen Stützrolle 55 eine insbesondere ringförmige, Partikel absorbierende Fangschleife 70 angeordnet wird, wie dies in Fig. 6 schematisiert angedeutet ist. Eine solche Fangschleife 70 kann auch umschließend zu mehreren Stützrollen 55 einer Stützrollengruppe 64, oder auch mehrerer Stützrollengruppen 64, vorgesehen werden, wobei eine etwa erforderliche Energieversorgung beispielsweise induktiv und berührungsfrei für den Läufer 47 ausgehend vom Schlepper 48 erfolgen kann.

## Patentansprüche

1. Modul für modular aufgebaute Reinraumanlagen mit einem Gehäuseinnenraum (4), in dem eine Speichereinheit (7) und ein Handhabungsgerät (8) angeordnet sind, das ein Antriebsteil (9) für einen Greiferarm (10) aufweist, wobei das Antriebsteil (9) und der Greiferarm (10) in über eine membranartige Trennwand (15) abgeteilten Raumteilen (16, 17) des Gehäuseinnenraumes (4) angeordnet sind und das Antriebsteil (9) und der Greiferarm (10) über einen zum Antriebsteil (9) verstellbar angetrieben abgestützten Schlepper (48) und einem zum Greiferarm (10) drehfest angeordneten Läufer (47) verkuppelt sind, wobei der Schlepper (48) und der bezogen auf die Trennwand (15) gegenüberliegende Läufer (47) mit einander entsprechenden Tragstrukturen (50, 51) versehen sind, die Rollenabstützungen (52) mit einander gegenüberliegenden Stützrollen (55, 56) und den Tragstrukturen (50, 51) zugehörige Magnetpaarungen (53, 54) aufweisen, wobei über zentrierende Magnetpaarungen (53) der den Tragstrukturen (50, 51) zugehörigen Magnetpaarungen (53, 54) das Antriebsteil (9) und der Greiferarm (10) überbrückend zur Trennwand (15) berührungsfrei magnetisch bewegungsgekoppelt sind, und wobei abstützende Magnetpaarungen der den Tragstrukturen zugehörigen Magnetpaarungen das Antriebsteil zum Greiferarm entsprechend der Abstützung über die Stützrollen abstützen,
**dadurch gekennzeichnet,**
**dass** die durch zur Trennwand (15) gegenüberliegende Stützrollen (55, 56) gebildeten Rollenabstützungen (52) zu einer Stützrollengruppe (64) mit zumindest drei Stützrollen (55, 56) zusammengefasst sind, die zueinander versetzt auf den Eckpunkten eines Vielecks, insbesondere eines Dreieckes, liegend derart angeordnet sind, dass bei zwei auf einer Seite der Trennwand (15) und auf dem gleichen Umkreis (65) zur Drehachse (67) der Drehabstützung (11) liegenden Stützrollen (55) die gegenüberliegende dritte Stützrolle (56) in angrenzender Lage zu diesem auf einem abweichenden, insbesondere kleineren, Umkreis (69) angeordnet ist.

2. Modul nach Anspruch 1,
**dadurch gekennzeichnet,**
**dass** zumindest ein Teil der untergreifend zur Trennwand (15) am unter dem Läufer (47) liegenden Schlepper (48) vorgesehenen Stützrollen (56) gegen die Trennwand (15) federnd vorgespannt abgestützt ist.

3. Modul nach einem der Ansprüche 1 oder 2,
**dadurch gekennzeichnet,**
**dass** der Schlepper (48) und der Läufer (49) mehrere, auf einander entsprechenden Eckpunkten eines Vielecks, insbesondere eines Dreiecks oder Vierecks, liegende Stützrollengruppen (64) aufweisen.

4. Modul nach einem der vorhergehenden Ansprüche,
**dadurch gekennzeichnet,**
**dass** umschließend zu am Läufer (47) vorgesehenen Stützrollen (55) der Rollenabstützungen (56) benachbart zur Trennwand (15) eine sorbierend arbeitende, insbesondere unter Hochspannung stehende Partikelfangschleife (70) vorgesehen ist.

## Claims

1. Module for modularly constructed clean-room facilities with a housing's interior space (4), in which a storage unit (7) and a handling unit (8) are arranged, which comprises a drive part (9) for a gripper arm (10), wherein the drive part (9) and the gripper arm (10) are arranged in spatial parts (16, 17) of the housing's interior space (4) divided by a membrane-like partition wall (15) and the drive part (9) and the gripper arm (10) are coupled via a supported skid (48) that can be adjusted in a driven manner with relation to the drive part (9) and a runner (47) arranged in a torque-proof manner with relation to the gripper arm (10), wherein the skid (48) and the runner (47) lying opposite with relation to the partition wall (15) are provided with support structures (50, 51) corresponding to one another, which comprise roller supports (52) with support rollers (55, 56) lying opposite to one another and magnetic pairings (53, 54) associated with the support structures (50, 51), wherein the drive part (9) and the gripper arm (10) are magnetically motion-coupled to the partition wall (15) in a bridging and contact-free manner by a centring magnetic pairings (53) of the magnetic pairings (53, 54) associated with the support structures (50, 51) and wherein supporting magnetic pairings of the magnetic pairings associated with the support structures support the drive part (9) belonging to the gripper arm according to the support via the support rollers,
**characterized in that**
the roller supports (52) formed by the support rollers (55, 56) lying opposite to the partition wall (15) are consolidated into a support roller group (64) with at least two support rollers (55, 56), which are arranged in an offset manner on the corner points of a polygon, in particular of a triangle, in such a way that, in the case of a side of the partition wall (15) and support rollers (55) lying on the same perimeter (65) to the rotational axis (67) of the rotary support (11), the opposite-lying third support roller (56) is arranged in an adjacent position to this on a deviating perimeter (69), thereby being smaller in particular.

2. Module according to Claim 1,
**characterized in that**
at least one part of the support rollers (56) provided gripping under the partition wall (15) on the skid (48) lying under the runner (47) is supported against the partition wall (15) in a spring-preloaded manner.

3. Module according to one of the Claims 1 or 2,
**characterized in that**
the skid (48) and the runner (49) comprise a plurality of support roller groups (64) lying on corner points of a polygon corresponding to one another, in particular, of a triangle or rectangle.

4. Module according to any one of the preceding claims,
**characterized in that**
a particle-capture loop (70) with a sorbing function, particularly being live with a high voltage level is provided surrounding the support rollers (55) of the roller supports (56) adjacent to the partition wall (15) on the runner (47).

## Revendications

1. Module destiné à des installations de salle blanche modulaires, le module comprenant un espace intérieur de boîtier (4) dans lequel sont disposés une unité de stockage (7) et un dispositif de manutention (8) qui comporte une partie d'entraînement (9) destinée à un bras de préhension (10), la partie d'entraînement (9) et le bras de préhension (10) étant disposés dans des parties d'espaces (16, 17), divisées par une paroi de séparation (15) de type membrane, de l'espace intérieur de boîtier (4) et la partie d'entraînement (9) et le bras de préhension (10) étant accouplés par un tracteur entraîné (48) supporté de manière déplaçable par rapport à la partie d'entraînement (9) et un rotor (47) disposé solidairement en rotation par rapport au bras de préhension (10), le tracteur (48) et le rotor (47) opposé par rapport à la paroi de séparation (15) étant pourvus de structures porteuses (50, 51), correspondant les unes aux autres, qui comportent des supports de rouleaux (52) pourvus de rouleaux de support (55, 56) opposés les uns aux autres et de paires d'aimants (53, 54) associées aux structures porteuses (50, 51), la partie d'entraînement (9) et le bras de préhension (10) étant accouplés cinématiquement et magnétiquement sans contact, en pontant la paroi de séparation (15), par des paires d'aimants de centrage (53) des paires d'aimants (53, 54) appartenant aux structures porteuses (50, 51), et des paires d'aimants de support des paires d'aimants
appartenant aux structures porteuses supportant la partie d'entraînement par rapport au bras de préhension en fonction du support par les rouleaux de support, **caractérisé en ce que**
les supports de rouleau (52) formés par les rouleaux de support (55, 56) opposés par rapport à la paroi de séparation (15) sont combinés pour former un groupe de rouleaux de support (64) qui comportent au moins trois rouleaux de support (55, 56) et qui sont disposés à plat sur les sommets d'un polygone, notamment d'un triangle, en étant décalés les uns des autres de telle sorte que, dans le cas de deux rouleaux de support (55) situés sur un côté de la paroi de séparation (15) et sur le même cercle (65) par rapport à l'axe de rotation (67) du support rotatif (11), le troisième rouleau de support (56) opposé est disposé dans la position adjacente à ce cercle sur un cercle différent (69), en particulier plus petit.

2. Module selon la revendication 1,
**caractérisé en ce que**
au moins une partie des rouleaux de support (56), prévus pour s'engager au-dessous de la paroi de séparation (15) au niveau du tracteur (48) se trouvant sous le rotor (47), est supportée de manière précontrainte élastiquement contre la paroi de cloison (15) .

3. Modulé selon l'une des revendications l'ou 2,
**caractérisé en ce que**
le tracteur (48) et le rotor (49) comportent une pluralité de groupes de rouleaux de support (64) situés aux sommets, correspondants les uns aux autres, d'un polygone, en particulier d'un triangle ou d'un quadrilatère.

4. Module selon l'une des revendications précédentes,
**caractérisé en ce que**
une boucle de piégeage de particules (70) fonctionnant à sorption, notamment à haute tension, est prévue de manière adjacente à la paroi de séparation (15) et de façon à entourer des rouleaux de support (55), prévus au niveau du rotor (47), des supports de rouleaux (56).
